Europäisches Patentamt

European Patent Office

Office européen des brevets

(19)

(11) Publication number: **0 171 292 B1**

(12) # EUROPEAN PATENT SPECIFICATION

(45) Date of publication of patent specification: **06.11.91**    (51) Int. Cl.⁵: **G11C 8/00**, G11C 11/411

(21) Application number: **85305659.6**

(22) Date of filing: **09.08.85**

(54) Semiconductor memory device.

(30) Priority: **10.08.84 JP 167395/84**

(43) Date of publication of application:
**12.02.86 Bulletin 86/07**

(45) Publication of the grant of the patent:
**06.11.91 Bulletin 91/45**

(84) Designated Contracting States:
**DE FR GB**

(56) References cited:
**DE-A- 3 242 234**
**US-A- 3 365 707**
**US-A- 4 250 407**

**IBM TECHNICAL DISCLOSURE BULLETIN, vol.
20, no. 8, January 1978, pages 3155-3156,
New York, US; G. BOUDON et al.: "Top-line
selection circuit in a memory cell"**

(73) Proprietor: **FUJITSU LIMITED**
**1015, Kamikodanaka Nakahara-ku**
**Kawasaki-shi Kanagawa 211(JP)**

(72) Inventor: **Okajima, Yoshinori**
**Fukuju-so 7 5-10-7, Miyazaki Miyamae-ku**
**Kawasaki-shi Kanagawa 213(JP)**
Inventor: **Awaya, Tomoharu**
**768-25, Nase-cho Totsuka-ku**
**Yokohama-shi Kanagawa 245(JP)**

(74) Representative: **Sunderland, James Harry et al**
**HASELTINE LAKE & CO Hazlitt House 28**
**Southampton Buildings Chancery Lane**
**London WC2A 1AT(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

**Description**

The present invention relates to semiconductor memory devices manufactured by the master slice method, and more particularly but not exclusively it relates to emitter coupled logic (ECL) type memory devices.

Semiconductor memory devices such as ECL memory devices using bipolar transistors have been made with increasingly larger capacities in recent years. This has been accompanied by an increase of the load of word lines. To deal with this increased load, it is effective to form a driver circuit for the word lines in a two-stage emitter-follower (EF) construction or a darlington connection to raise the drive capacity. This enables higher speed operation and lower power consumption.

Semiconductor memory devices such as ECL memory devices come in two types, "10K" and "100K". The input and output levels of these may be almost the same, but their temperature characteristics may be different. That is, the 10K type may have a temperature coefficient the same as that of a forward voltage $V_F$ of a diode, while the 100K type may internally compensate for temperature characteristics to achieve a temperature coefficient of zero. Which of these are used depends on the specific application of the device.

Another difference between the two types lies in the voltage of the power source. An ECL memory device operates between an earth potential ($V_{CC}$) and a negative power source ($V_{EE}$). The negative power source $V_{EE}$ is usually, for example, -5.2V for a 10K type and -4.5V for a 100K type. That is, a 10K type can operate with a power source 0.7V lower (more negative) than the 100K type, i.e. the power source margin of the 10K type is larger than the 100K type. Those two types have the same latent power source margin.

The only difference in the conventional circuit constructions of the 100K and 10K types of memory device is that the 100K type provides a diode in an output buffer gate for compensating for the temperature characteristic of the output voltage and another diode for adjusting the threshold level of an input buffer gate due to receiving constant voltage swings. Therefore, 100K and 10K types can be manufactured by almost the same wafer process; the additional diodes are always prepared (fabricated) and to manufacture the 100K type the wiring process is changed to add the diodes in those circuits. This method is called the master slice method.

When a word line driver is constructed in two stages, the voltages of the word lines become low and the total levels are supplied to word lines and bit lines become low corresponding to a voltage drop of the word lines. This makes disadvantageous the power source margin in the 100K type, which must be operated by a relatively shallow supply voltage e.g. around -4.5V. Actually, most memory devices which have two-stage word drivers cannot operate at -4.5V.

This means that the word line driver in a 100K type must be constructed as a one stage word driver. When using the master slice method and conventional circuit technology, therefore, even the "10K" type must have a word driver constructed in one stage. This, however, means high-speed operation cannot be obtained even with a 10K type despite its sufficient power source margin.

An embodiment of the present invention can provide a memory device, manufactured by the master slice method, able to be formed with a two-stage word line driver if it has a sufficient power source margin, so as to operate rapidly, and able to be formed with a one-stage word line driver when necessary, to secure a sufficient power source margin.

An embodiment of the present invention can provide for the formation of an ECL type memory device having an optimal number of word line driver stages (having regard to the power source margin at which the device will be used).

According to the present invention, there is provided a semiconductor memory device comprising: a high potential source; a low potential source; a word line driver portion - which is connected between said high potential source and a word line and which receives a selection signal to make the selection level of the selected word line by a predetermined potential lower than said high potential source; and a plurality of memory cells connected to said word lines, characterised in that said semiconductor memory device forms a first device wherein said low potential source is connected to a first low potential source, or a second device wherein said low potential source is connected to a lower second low potential source; that a plurality of driver transistors is provided in said word line driver portion to enable construction of a plurality of stages; that in said first device, one stage is provided, which stage consists of one driver transistor having its collector connected to the high potential source, its base connected to said selection signal and its emitter connected to said word line, that in said second device, two stages are provided, which stages each consists of one driver transistor, the first of said driver transistors having its collector connected to said high potential source, its base connected to said selection signal, and its emitter connected to the second low potential source, the second of said driver transistors having its collector connected to the high potential source, its base connected to the emitter of said first driver transistor and its emitter to the word line, and that the selection level of the word lines in said first device is made higher than the selection level of the word lines in said second device.

The number of stages of the driver transistors when the first low potential source is connected to the low potential source is thus smaller than when the second potential source is connected. The selection level of the word lines when the first low potential source is connected is made higher than when the second low potential source is connected.

Reference is made, by way of example, to the accompanying drawings in which:

Figure 1 is a schematic circuit diagram of an ECL memory device according to an embodiment of the present invention;

Figures 2A to 2D are diagrams of essential portions of an embodiment of the present invention and level diagrams thereof;

Figure 3 is a connection diagram for explaining the temperature coefficient in an ECL circuit;

Figure 4 is a graph explaining the temperature coefficient in an ECL circuit; and

Figure 5 is a diagram explaining differences of the power source margin in the prior art and in embodiments of the present invention.

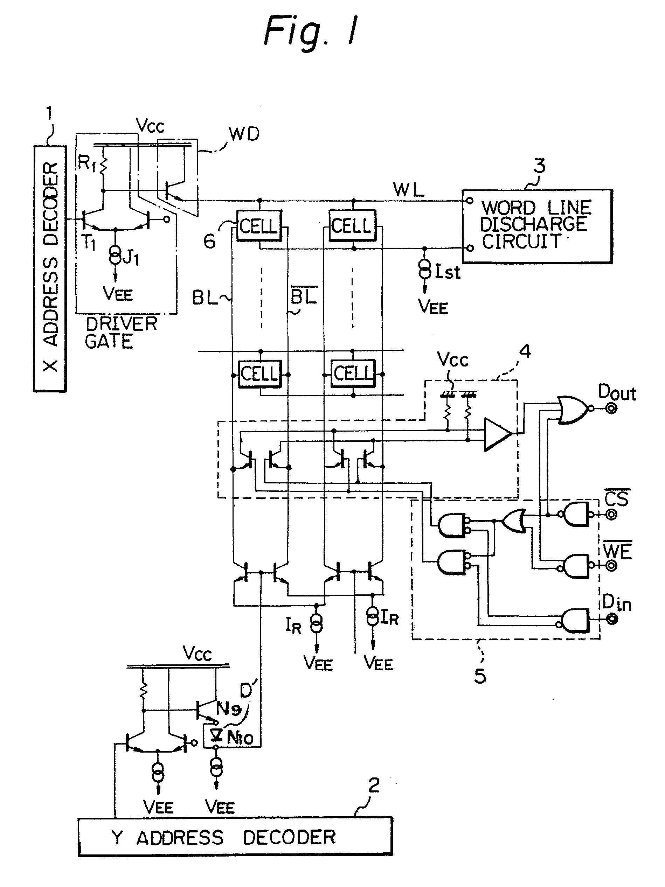

Figure 1 is a schematic circuit diagram of an ECL memory device. In Figure 1, 1 is an X address decoder for selecting a word line WL, 2 a Y address decoder for selecting a bit line BL, 3 a word line discharge circuit for discharging word lines WL so as to accelerate a fall in potential, 4 a sense circuit which amplifies selected cell information, 5 a circuit which controls read (R), write (W), and chip select (CS) operations, 6 memory cells (CELL) arranged in a matrix, and WD a word line driver shown schematically.

When a chip select signal $\overline{CS}$ becomes L (low), the ECL memory chip can operate. When a write enable signal $\overline{WE}$ is low, data $D_{in}$ is written into a cell 6 selected by the decoders 1 and 2. When the write enable signal $\overline{WE}$ is H (high), the data $D_{out}$ is read out from the cell 6 selected by the decoders 1 and 2. In Figure 1, the word line driver WD is formed as one transistor and thus is a "one-stage" construction.

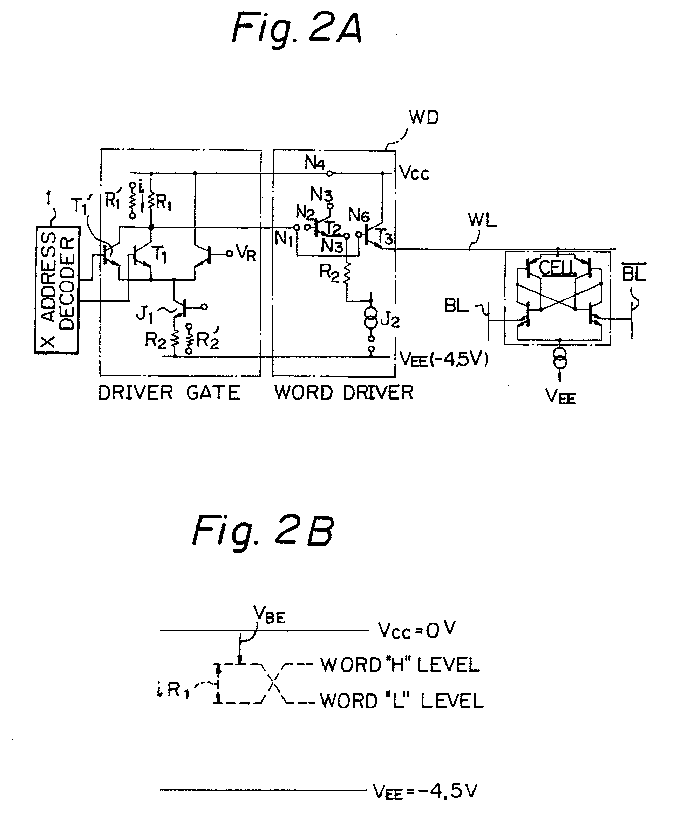

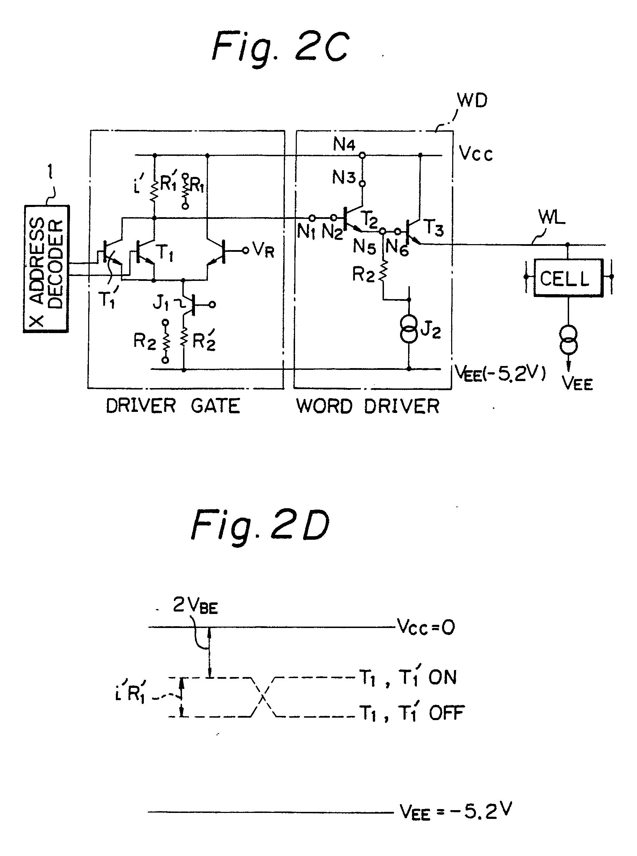

Figures 2A and 2C are circuit diagrams of essential portions of an embodiment of the present invention, including a construction from the X address decoder 1 to the word line driver WD in Figure 1. Figures 2B and 2D are level diagrams of the circuits shown in Figures 2A and 2C, respectively. For selectively forming, for example, a two-stage or one-stage construction, the word line driver WD is provided with two EF transistors $T_2$ and $T_3$. When a 100K type memory device-having a high (shallow) potential source $V_{EE}$, such as -4.5V, is desired, the connection shown in Figure 2A is made. When a 10K type memory device having a low (deep) potential source $V_{EE}$, such as -5.2V, is desired, the connection shown in Figure 2C is made.

In other words, in the case of a 10K type, a two-stage construction is formed using the two EF transistors $T_2$ and $T_3$, an emitter resistor $R_2$ of the transistor $T_2$, and a constant current source $J_2$ - (connected by wire) so as to raise the driveability (driving ability). In this regard, note, as shown in Figure 2A and Figure 2C, that there are provided two kinds of load resistors $R_1,R_1'$ and resistors $R_2,R_2'$ in the constant current source $J_1$.

In Figures 2A and 2C, the values of the resistors $R_1$ and $R_2$, which constitute high power element means, are selected to be lower than the values of the resistors $R_1'$ and $R_2'$, respectively, which constitute low power element means. In the case of the 10K type shown in Figure 2C, the resistors $R_1'$ and $R_2'$ are connected. As a result, the current i' flowing in the resistor $R_1'$ is smaller than the current i flowing in the resistor $R_1$ in the circuit of Figure 2A. By the provision of the two kinds of resistors and by change of the connection of the resistors, it is therefore possible to reduce the power loss. The relationship between the levels of the high potential source $V_{CC}$, second low potential source $V_{EE}$, and a selected word line driver is shown in Figure 2D. As shown in Figure 2D, the selection level of the word line becomes lower by the value $2V_{BE}$, corresponding to the two stages, than the high potential source $V_{CC} = 0$, in the circuit of Figure 2C.

For the 100K type of device, as shown in Figure 2A, the transistor $T_2$, resistor $R_2$, and constant current source $J_2$ are not used. Connection is made so that the output of the decoder 1 is directly supplied to the base of the transistor $T_3$, that is, the word line driver is formed in a one-stage construction. As shown in Figure 2B, the potential of the selection level of the word line WL thus becomes higher by a value $V_{BE}$ corresponding to one stage between the base and the emitter (above 0.7V) of the transistor $T_2$ than the two-stage construction mentioned above.

As explained above, in the 10K type of device, since the low potential source $V_{EE}$ can be deep enough, i.e. -5.2V, the word driver can have two-stage driver transistors $T_2,T_3$ so that high speed operation is possible because a word line pulling up ability is better than with a one-stage driver. Furthermore, although the power consumption in a 10K type would normally be large because of such a deep low potential source, since the word driver comprises a two-stage driver which can operate by feeding a smaller base current, the driver gate can use the larger resistors $R_1',R_2'$. This means that the power consumption in the driver gate can be reduced so as to reduce or eliminate this drawback of using a deep potential source.

On the other hand, in the 100K type, since the low potential source $V_{EE}$ is not deep enough for a two-stage word driver, the word driver comprises only a one-stage word line transistor $T_3$. Therefore, even though the potential difference between the potential sources $V_{CC}-V_{EE}$ is relatively small, since the word line selection level is high enough, the potential margin of the memory is large enough to secure proper operation.

In the manufacturing process, a master bulk having the two driver transistors $T_2$, $T_3$, two resistors $R_1,R_1'$, $R_2,R_2'$, another resistor $R_2$, and current source circuit $J_2$, is manufactured for the both 10K and 100K type. In a process of forming wire patterns on the master bulk for producing finished devices, 10K and 100K type devices are selectively produced by connecting or disconnecting the nodes $N_1$ to $N_6$ as shown in Figure 2A and Figure 2C.

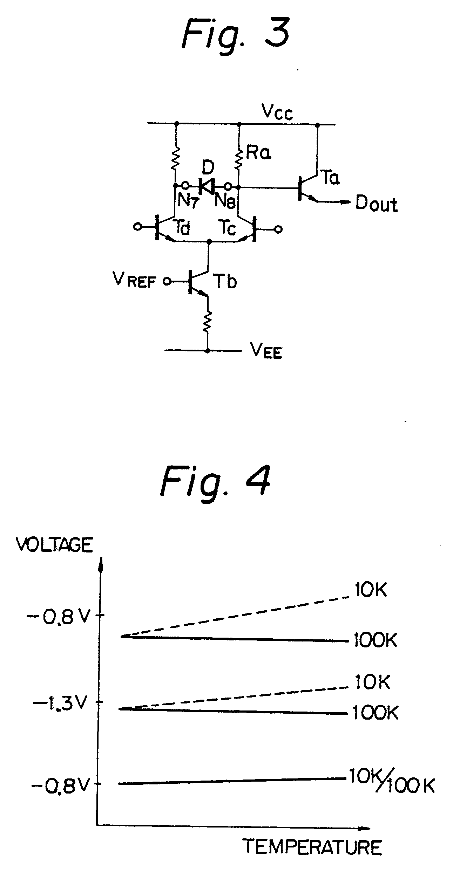

Figure 3 is a circuit diagram showing a difference between the 10K and 100K types. As shown, a diode D (as level shift means) may be used for compensating for temperature in the 100K type, but not in the 10K type. This is achieved by connecting or not connecting the diode D between the nodes $N_7$ and $N_8$. The circuit is that of a usual ECL gate. In the case of a 10K type, the temperature characteristic of the EF transistor $T_a$ and a resistor $R_a$ in the output stage appears at the output $D_{out}$. Figure 4 is a graph of temperature characteristics, the broken lines showing the 10K type and the solid lines the 100K type, where the intermediate value of the ECL level is assumed as a standard -1.3V, the H (high) level is assumed as a standard -0.8V and the L (low) level as a standard -1.8V, for example. The H level in a 100K type considerably increases along with a temperature rise. The intermediate value increases next in amount. The L level does not vary much at all.

The reason why the L level stabilises is that the reference voltage $V_{REF}$ of the transistor $T_b$ which forms the constant current source can be given a temperature characteristic. That is, temperature variations of the output level arise since the base-emitter voltage $V_{BE}$ of the transistor $T_a$ decreases when the temperature rises. If the current flowing in the resistor $R_a$ is made to increase when the temperature rises, the decrease of $V_{BE}$ can be compensated for and the output level made constant. The current flowing in the resistor $R_a$ can be changed by the current passed by the transistor $T_b$, therefore, by the base voltage $V_{REF}$. However, the H level appears when the transistor $T_c$ is in an off state, thus is subject to the temperature characteristic of the resistor $R_a$ and the transistor $T_a$ and cannot be compensated for by the current passed by the transistor $T_b$.

Therefore, in the 100K type, the diode D is connected with the polarity shown in Figure 3. The base potential of the transistor $T_a$ is made constant by referring to the collector potential (this is stabilized at low level) of the transistor $T_d$, which is on when the output is high level. Then the emitter potential of the transistor $T_a$, that is, the output level, is clamped at the level which rises $V_F$ from the L level collector potential of the stable transistor $T_d$ mentioned above and falls by $V_{BE}$. As the forward voltage $V_F$ of the diode D is for example equal to the base-emitter voltage $V_{BE}$ of the transistor $T_a$ (about 0.7 to 0.8V), the output level (H level) is proportional to (equal to) the (L level) collector potential of the transistor $T_d$, that is, constant.

At the L level, the output level $D_{out}$ has a value which is lower by a value corresponding to one stage of the base-emitter voltage $V_{BE}$ of the transistor $T_a$ than the collector potential of the transistor $T_c$ ; this is also constant. Therefore, no temperature coefficient exists in the ECL levels of a 100K type device. However, in the 10K type, as the diode D is not connected, that L level of the output does not change due to temperature variations. However, temperature variations of $V_{BE}$ appear at the H level.

Regarding the determination of the potential of the 100K type, a 100K type having such a temperature characteristic usually is required to be able to operate at a power source voltage shallower than a 10K type. If for example the word line driver is formed in two stages, the potential of the selected word line excessively decreases by an amount of one stage of $V_{BE}$. Therefore, a power source deeper by this amount is required. A power source of for example -4.5V of a 100K type is thus disadvantageous for such a circuit construction.

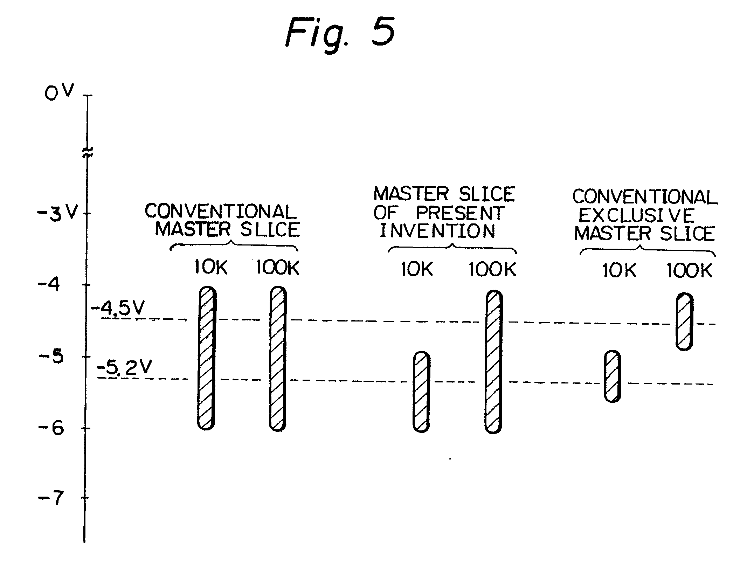

Figure 5 is a diagram of power source margins. It shows example ranges of usable voltages (oblique line portions) for 10K and 100K types made by the conventional common master slice method, the common master slice method of the present invention, and the conventional "exclusive" master slice method ("exclusive" meaning methods exclusively for the 10K type and for the 100K type). The range of usable voltage is determined by taking a suitable margin between the minimum voltage which is required to operate the circuit elements as an upper limit and the high voltage at which breakdown of elements can be caused as a lower limit. The power source range of the 10K and 100K types made by the conventional master slice method is set so as to cover -5.2V to -4.5V for the purpose of operation even at -4.5V. Here, only the temperature compensation circuit is changed between the 10K and 100K types. The word line driver is a one-stage construction in both cases.

Even in conventional cases, 10K types have word line drivers of two-stage constructions. However, this is in the case of the exclusive 10K method and does not operate by a -4.5V power source. In the case of the exclusive 100K method, the word line driver is of the one-stage construction and operates by a -4.5V power source.

Contrary to this, the 100K type of memory device produced by the common master slice method of the present invention may be the same as that produced by the conventional common master slice method and further the 10K type has a word line driver formed in a two or more stage construction. Although a power source near -5.2V, for example, is required by the 10K type and the driver cannot operate by a -4.5V power source, for example, the driveability (driving ability) increases.

In the present invention, a common master slice method is used to produce 10K and 100K type semiconductor memory devices, e.g. ECL memory devices. Therefore, the word line driver is made to be able to be formed with one or two or more stages and a temperature compensation diode D is made connectable (as a semi finished element provided on master slice). When the word line driver is formed in a two or more-stage construction, other portions of the device should be adjusted correspondingly. For example, it may be required to adjust the level by inserting level shift means into other requisite portions, e.g., by connecting a diode D' between the nodes $N_9$ and $N_{10}$ as shown in Figure 1. Such diodes are previously prepared. In the wiring process, the diode D' is selectively connected according to the device type in the same way of the word driver circuit and driver gate in Figure 2A,2C.

As explained above, in a semiconductor memory device such as an ECL type, generally the driver transistor of the word line driver is placed on for the selected word line to place it at a selection level lower by a predetermined level than the high potential source $V_{CC}$. The non-selected word line is placed at a nonselection level lower than the selection level. The read and write operations are carried out basically by operating the ECL circuit with respect to the levels of the selected memory cell of the selected word line, the levels of the write transistors and read transistors, etc. Therefore, if the level difference between the high potential source $V_{CC}$ and the low potential source $V_{EE}$ is sufficiently large, the power source margin becomes large.

Therefore, in the present invention, in the case of a 10K type having a large difference between $V_{CC}$ and $V_{EE}$ (e.g. 0V and -5.2V), the word line driver is formed in a two or more-stage construction so as to enable high speed of operation. In the case of a 100K type having a smaller (insufficiently large) difference between $V_{CC}$ and $V_{EE}$ (e.g. 0V and -4.5V), the word line driver is formed in a one or more-stage construction so as to ensure the power source margin. That is, the selection level of the word line WL becomes ($V_{CC}$ - $2V_{BE}$) in the two-stage 10K type and ($V_{CC}$ - $V_{BE}$) in the one-stage 100K type.

As explained above, according to an embodiment of the present invention, a 100K ECL memory device having no temperature coefficient at the ECL levels of output and a 10K ECL memory device having a temperature coefficient can be manufactured by a common master slice. Further, the word line driver in the latter can be formed in a two or more-stage construction, enabling high-speed operation.

In general, an embodiment of the present invention can provide two types of semiconductor memory device manufactured by a common master slice. The first type of device is operable with power source voltages of a first power source margin, and has a word line driver portion including a first number of stages of driver transistors. The second type of device is operable with power source voltages of a second power source margin, greater than the first power source margin, and has a word line driver portion including a second number of stages of driver transistors, higher than the first number of stages of driver transistors.

## Claims

1. A semiconductor memory device comprising:
   a high potential source ($V_{CC}$);
   a low potential source ($V_{EE}$);
   a word line driver portion (WD) which is connected between said high potential source and a word line (WL) and which receives a selection signal (N1) to make the selection level of the selected word line by a predetermined potential ($V_{BE}$) lower than said high potential source; and
   a plurality of memory cells connected to said word lines,
   characterised in that said semiconductor memory device forms a first device wherein said low potential source ($V_{EE}$) is connected to a first low potential source (J1), or a second device wherein said low potential source ($V_{EE}$) is connected to a lower second low potential source (J2);
   that a plurality of driver transistors (T2,T3) is provided in said word line driver portion to enable construction of a plurality of stages;
   that in said first device, one stage is provided, which stage consists of one driver transistor (T3) having its collector connected to the high potential source ($V_{CC}$), its base connected to said selection signal and its emitter connected to said word line (Fig. 2A),
   that in said second device, two stages are provided, which stages each consists of one driver transistor, the first (T2) of said driver transistors having its collector connected to said high potential source, its base connected to said selection signal, and its emitter connected to the second low potential source (J2), the second (T3) of said driver transistors having its collector connected to the high potential source ($V_{CC}$), its base connected to the emitter of said first driver transistor (T2) and its emitter to the word line (Fig. 2C), and

that the selection level ($V_{CC} - V_{BE}$) of the word lines in said first device is made higher than the selection level ($V_{CC} - 2 V_{BE}$) of the word lines in said second device.

2. A semiconductor memory device according to claim 1, further provided with a driver gate circuit for supplying said selection signal to said word line driver portion (WD);

each of said driver transistors (T2,T3) being provided with a collector connected to said high potential source ($V_{CC}$), a base connected so as to receive said selection signal, and an emitter connected to said word lines (WL);

said driver gate circuit being provided with high power element means ($R_1, R_2$) and low power element means ($R_{1'}, R_{2'}$);

said high power element means ($R_1, R_2$) being connected and used when said first low potential source (J1) is connected to said low potential source ($V_{EE}$); and

said low power element means ($R_{1'}, R_{2'}$) being connected and used when said second low potential source (J2) is connected to said low potential source ($V_{EE}$).

3. A semiconductor memory device according to claim 1, wherein level shift means (D) is provided in a bit line driver, said level shift means is used when said second low potential source (J2) is connected, and said level shift means is not used when said first low potential source (J1) is connected.

4. A semiconductor memory device according to claim 1, 2 or 3, wherein the device is formed as said first device or said second device depending on a wiring process in fabrication of the device, said first device being suitable for operation with a lower power source margin and said second device being suitable for operation with a higher power source margin.

**Revendications**

1. Dispositif mémoire semi-conducteur comprenant :

une source à potentiel haut ($V_{CC}$) ;

une source à potentiel bas ($V_{EE}$) ;

une partie de pilotage de lignes de mot (WD) qui est connecté entre ladite source à potentiel haut et une ligne de mot (WL) et qui reçoit un signal de sélection (N1) qui rend le niveau de sélection de la ligne de mot, d'un potentiel prédéterminé ($V_{BE}$), inférieur à celui de ladite source à haut potentiel ; et

une pluralité de cellules mémoire connectées aux dites lignes de mot,

caractérisé en ce que ledit dispositif mémoire semi-conducteur forme un premier dispositif dans lequel ladite source à potentiel bas ($V_{EE}$) est connectée à une première source à potentiel bas ($J_1$) ou un second dispositif dans lequel ladite source à potentiel bas ($V_{EE}$) est connectée à une seconde source a potentiel bas ($J_2$), inférieur ;

en ce qu'une pluralité de transistors de pilotage (T2, T3) sont disposés sur ladite partie de pilotage de lignes de mot pour permettre la construction d'une pluralité d'étages ;

en ce que, dans ledit premier dispositif, on prévoit un seul étage, lequel étage consiste en un unique transistor de pilotage (T3) ayant son collecteur connecté à la source à potentiel haut ($V_{CC}$), sa base connectée audit signal de sélection et son émetteur connecté à ladite ligne de mot (Fig. 2A),

en ce que, dans ledit second dispositif, on prévoit deux étages, lesquels étages consistent chacun en un transistor de pilotage, le premier (T2) desdits transistors de pilotage ayant son collecteur connecté à ladite source à potentiel haut, sa base connectée audit signal de sélection et son émetteur connecté à la seconde source à potentiel bas ($J_2$), le second (T3) desdits transistors de pilotage ayant son collecteur connecté à la source à potentiel haut ($V_{CC}$), sa base connectée à l'émetteur dudit premier transistor de pilotage (T2) et son émetteur à la ligne de mot (Fig. 2C), et

en ce que le niveau de sélection ($V_{CC} - V_{BE}$) des lignes de mot dudit premier dispositif est rendu plus grand que le niveau de sélection ($V_{CC} - 2V_{BE}$) des lignes de mot dudit second dispositif.

2. Dispositif mémoire semi-conducteur selon la revendication 1, muni en outre d'un circuit de porte de pilotage (amplificateur) pour fournir ledit signal de sélection à ladite partie (WD) de pilotage de lignes de mot ;

chacun desdits transistors de pilotage (T2, T3) étant muni d'un collecteur connecté à ladite source de potentiel haut ($V_{CC}$), d'une base connectée de façon à recevoir ledit signal de sélection, et d'un émetteur connecté aux dites lignes de mot (WL) ;

ledit circuit de porte de pilotage étant muni de moyens formant des éléments haute puissance ($R_1$, $R_2$) et de moyens formant des éléments basse puissance ($R'_1$, $R'_2$) ;

lesdits moyens ($R_1$, $R_2$) formant des éléments haute puissance étant connectés et utilisés quand ladite première source de potentiel bas ($J_1$) est connectée à ladite source de potentiel bas ($V_{EE}$) ;

lesdits moyens formant des éléments basse puissance ($R'_1$, $R'_2$) étant connectés et utilisés quand ladite seconde source à potentiel bas ($J_2$) est connectée à ladite source de potentiel bas ($V_{EE}$).

3. Dispositif mémoire semi-conducteur selon la revendication 1, dans lequel des moyens de décalage de niveaux (D) sont disposés sur un pilote de lignes de bit, lesdits moyens de décalage de niveaux sont utilisés quand ladite seconde source à potentiel bas (J2) est connectée et lesdits moyens de décalage de niveaux ne sont pas utilisés quand ladite première source à potentiel bas ($J_1$) est connectée.

4. Dispositif mémoire semi-conducteur selon les revendications 1, 2 ou 3, dans lequel le dispositif est réalisé sous la forme dudit premier dispositif ou dudit second dispositif selon un procédé de câblage lors de la fabrication du dispositif, ledit premier dispositif étant prévu pour fonctionner avec une marge de source d'alimentation plus petite et ledit second dispositif étant prévu pour fonctionner avec une marge de source d'alimentation plus grande.

**Patentansprüche**

1. Halbleiterspeichervorrichtung mit:
einer Hochpotentialquelle ($V_{CC}$);
einer Niedrigpotentialquelle ($V_{EE}$);
einem Wortleitungstreiberabschnitt (WD), der zwischen der genannten Hochpotentialquelle und einer Wortleitung (WL) verbunden ist und ein Auswahlsignal (N1) empfängt, um den Auswahlpegel der ausgewählten Wortleitung um ein vorbestimmtes Potential ($V_{BE}$) niedriger als die Hochpotentialquelle zu machen;
einer Vielzahl von Speicherzellen, die mit den genannten Wortleitungen verbunden sind;
dadurch gekennzeichnet, daß die genannte Halbleiterspeichervorrichtung eine erste Vorrichtung bildet, in der die genannte Niedrigpotentialquelle ($V_{EE}$) mit einer ersten Niedrigpotentialquelle (J1) verbunden ist, oder eine zweite Vorrichtung, in der die genannte Niedrigpotentialquelle ($V_{EE}$) mit einer niedrigeren zweiten Niedrigpotentialquelle (J2) verbunden ist;

daß eine Vielzahl von Treibertransistoren (T2,T3) in dem genannten Wortleitungstreiberabschnitt vorgesehen ist, um die Konstruktion einer Vielzahl von Stufen zu ermöglichen;

daß in der genannten ersten Vorrichtung eine Stufe vorgesehen ist, welche Stufe aus einem Treibertransistor (T3) besteht, dessen Kollektor mit der Hochpotentialquelle ($V_{CC}$) verbunden ist, dessen Basis mit den genannten Auswahlsignal verbunden ist und dessen Emitter mit der genannten Wortleitung verbunden ist (Fig. 2A),

daß in der genannten zweiten Vorrichtung zwei Stufen vorgesehen sind, welche Stufen jeweils aus einem Treibertransistor bestehen, wobei der erste (T2) der genannten Treibertransistoren einen Kollektor hat, der mit der genannten Hochpotentialquelle verbunden ist, und eine Basis, die mit dem genannten Auswahlsignal verbunden ist, und einen Emitter, der mit der genannten niedrigen zweiten Potentialquelle (J2) verbunden ist, und der zweite (T3) der genannten Treibertransistoren einen Kollektor hat, der mit der Hochpotentialquelle ($V_{CC}$) verbunden ist, eine Basis, die mit dem Emitter des ersten Treibertransistors (T2) verbunden ist, und einem Emitter, der mit der Wortleitung (Fig. 2C) verbunden ist, und

daß der Auswahlpegel ($V_{CC}$ - $V_{BE}$) der Wortleitungen in der genannten ersten Vorrichtung höher als der Auswahlpegel ($V_{CC}$ - 2 $V_{BE}$) der Wortleitungen in der genannten zweiten Vorrichtung gemacht ist.

2. Halbleiterspeichervorrichtung nach Anspruch 1, ferner mit einer Treibergateschaltung zum Liefern des genannten Auswahlsignals an den genannten Wortleitungstreiberabschnitt (WD);

wobei jeder der genannten Treibertransistoren (T2, T3) mit einem Kollektor, der mit der genannten hohen Potentialquelle ($V_{CC}$) verbunden ist, einer Basis, die so verbunden ist, daß sie das genannte Auswahlsignal empfängt, und einem Emitter, der mit der genannten Wortleitung (WL) verbunden ist, versehen ist;

wobei die genannte Treibergateschaltung mit Hochleistungselementeinrichtungen ($R_1$,$R_2$) und Niedrigleistungselementeinrichtungen ($R_{1'}$,$R_{2'}$) versehen ist;

die genannten Hochleistungselementeinrichtungen ($R_1$,$R_2$) angeschlossen und verwendet werden, wenn die genannte erste Niedrigpotentialquelle (J1) mit der genannten Niedrigpotentialquelle ($V_{EE}$) verbunden ist; und

die genannten Niedrigleistungselementeinrichtung ($R_{1'}$,$R_{2'}$) verbunden ist und verwendet wird, wenn die genannte zweite Niedrigpotentialquelle (J2) mit der genannten niedrigen Potentialquelle ($V_{EE}$) verbunden ist.

3. Halbleiterspeichervorrichtung nach Anspruch 1, bei der eine Pegelschiebeeinrichtung (D) in einem Bitleitungstreiber vorgesehen ist, die genannten Pegelschiebeeinrichtung verwendet wird, wenn die genannte zweite Niedrigpotentialquelle (J2) verbunden ist, und die genannte Pegelschiebeeinrichtung nicht verwendet wird, wenn die genannte erste niedrige Potentialquelle (J1) verbunden ist.

4. Halbleiterspeichervorrichtung nach Anspruch 1, 2 oder 3, bei der die Vorrichtung als die genannte erste Vorrichtung oder die genannte zweite Vorrichtung gebildet ist, abhängig von einem Verdrahtungsprozeß bei der Herstellung der Vorrichtung, wobei die genannte erste Vorrichtung für den Betrieb mit einem niedrigeren Leistungsquellenbereich geeignet ist und die genannte zweite Vorrichtung für den Betrieb mit einem höheren Leistungsquellenbereich geeignet ist.

# Fig. 1

# Fig. 2A

DRIVER GATE    WORD DRIVER

# Fig. 2B

## Fig. 2C

## Fig. 2D

# Fig. 3

# Fig. 4

Fig. 5